# EUROPÄISCHE PATENTSCHRIFT

(11) **EP 1 225 640 B1**
(45) Veröffentlichungstag und Bekanntmachung des Hinweises auf die Patenterteilung: **21.12.2011**
(21) Anmeldenummer: 02000506.2
(22) Anmeldetag: 09.01.2002
(51) Int. Cl.: H01L 31/0203, H01L 33/00

(54) **Optoelektronisches Bauelement mit Leiterstreifenaufbau**
Optoelectronic element with a structure of conductive striplines
Element optoélectronique comportant une structure de bandes conductrices

(30) Priorität: 18.01.2001 DE 10102119
(43) Veröffentlichungstag der Anmeldung: 24.07.2002
(73) Patentinhaber: Vishay Semiconductor GmbH, 74072 Heilbronn (DE)
(72) Erfinder: Giebler, Siegfried, 71543 Wüstenrot (DE); Herok, Georg, 74172 Neckarsulm (DE)
(74) Vertreter: Manitz, Finsterwald & Partner GbR

(56) Entgegenhaltungen:
- EP-A- 0 566 921
- PATENT ABSTRACTS OF JAPAN Bd. 1996, Nr. 02, 29. Februar 1996 (1996-02-29) & JP 07 288332 A (FUJITSU LTD), 31. Oktober 1995 (1995-10-31)
- PATENT ABSTRACTS OF JAPAN Bd. 017, Nr. 061 (E-1316), 5. Februar 1993 (1993-02-05) -& JP 04 267549 A (NEC CORP), 24. September 1992 (1992-09-24)

## Beschreibung

Die Erfindung betrifft ein optoelektronisches Bauelement mit Leiterstreifenaufbau nach dem Oberbegriff des Patentanspruchs 1 und ein Verfahren zum Herstellen nach dem Oberbegriff des Patentanspruchs 10. Ein derartiges Bauelement und Verfahren sind in der JP 07 228 332 A beschrieben.

Ein optoelektronisches Bauelement mit Leiterstreifenaufbau nach dem Stand der Technik ist beispielsweise aus der Europäischen Patentanmeldung EP 0 566 921 A1 bekannt. Dieses Bauelement weist zur elektromagnetischen Abschirmung innerhalb seines Gehäuses ein umgeklapptes Streifenteil auf, das vom Verguss umschlossen ist. Jedoch ist eine Mindestdicke des Vergussmaterials über der Abschirmung notwendig. Aus diesem Grund und aufgrund der internen Anordnung dieses Bauelements ist eine weitere Miniaturisierung nicht möglich. Ein weiterer Nachteil besteht darin, dass im Vergussmaterial zwischen den Halbleiterbauteilen und der Abschirmung Inhomogenitäten auftreten.

Aus dem Patent Abstract of Japan No. 11154758 A ist bekannt, zur elektromagnetischen Abschirmung das aus Kunstharz bestehende Gehäuse einer optischen Empfangseinheit für infrarote Steuersignale mit Nickel zu beschichten. Die Beschichtung des Kunstharzgehäuses mit einer Nickelschicht stellt ein sehr aufwändiges Verfahren dar. Eine zusätzliche Schwierigkeit stellt die Zone dar, die nicht mit Nickel beschichtet werden darf, um für Infrarotstrahlung transparent zu bleiben. Weiterhin ist es schwierig, die Nickelschicht an Masse anzuschließen.

Des weiteren sind zur elektromagnetischen Abschirmungen separate metallene Teile bekannt, beispielsweise aus den Dokumenten EP 0 524 406 A1 oder US 5 432 340, die als separate Abschirmbleche oder Hauben hergestellt und um die zu schützenden Bereiche der Bauelemente angeordnet werden.

Der Nachteil derartiger separater Abschirmbleche ist, dass zusätzlicher Aufwand bei der Montage der Bauelemente entsteht.

Der Erfindung liegt die Aufgabe zugrunde, ein optoelektronisches Bauelement mit Streifenaufbau so zu gestalten, dass eine Abschirmung seiner vor elektromagnetischer Störstrahlung zu schützenden Teile ohne zusätzlicher externe Abschirmmaßnahmen erfolgt.

Gelöst wird diese Aufgabe durch eine Anordnung mit den im Anspruch 1 angegebenen Merkmalen und ein Verfahren mit den im Anspruch 10 angegebenen Merkmalen.

Die Erfindung weist die Vorteile auf, dass gegenüber bisherigen Bauelementen sehr viel kleinere Gehäuseformen realisiert werden können, auch als Top-View-Side-View-Kombinationen (Top-View: optische Achse verläuft senkrecht zur Montageebene, Side-View: optische Achse verläuft parallel zur Montageebene). Trotzdem bleibt aufgrund der gewählten Konstruktion die galvanische Verbindung des Abschirmteils zu Masse erhalten.

Die Erfindung eignet sich insbesondere für optoelektronische Bauelemente wie beispielsweise Photomodule, die sowohl in Top-View-Position als auch in Side-View-Position zu montieren sind und die elektronische oder optoelektronische Halbleiterbauelemente enthalten, die vor elektromagnetischer Störstrahlung geschützt werden müssen.

Vorteilhafte Ausgestaltungen des Gegenstands nach Anspruch 1 und des Verfahrens nach Anspruch 10 sind in den Unteransprüchen angegeben.

Die Erfindung wird nun anhand eines Ausführungsbeispiels unter Zuhilfenahme der Zeichnung erläutert. Es zeigen
- Fig. 1:: einen mit elektronischen und optoelektronischen Halbleiterbau- elementen bestückten, zweiteiligen Leiterstreifen,
- Fig. 2:: den Leiterstreifen der Fig. 1, dessen erster Leiterstreifenbereich mit den Halbleiterbauelementen mit einem Verguss umhüllt ist und
- Fig. 3a, b:: zwei perspektivische Ansichten eines fertig montierten optoelek- tronischen Bauelements mit umgebogenem zweitem Leiterstrei- fenbereich zur Abschirmung.

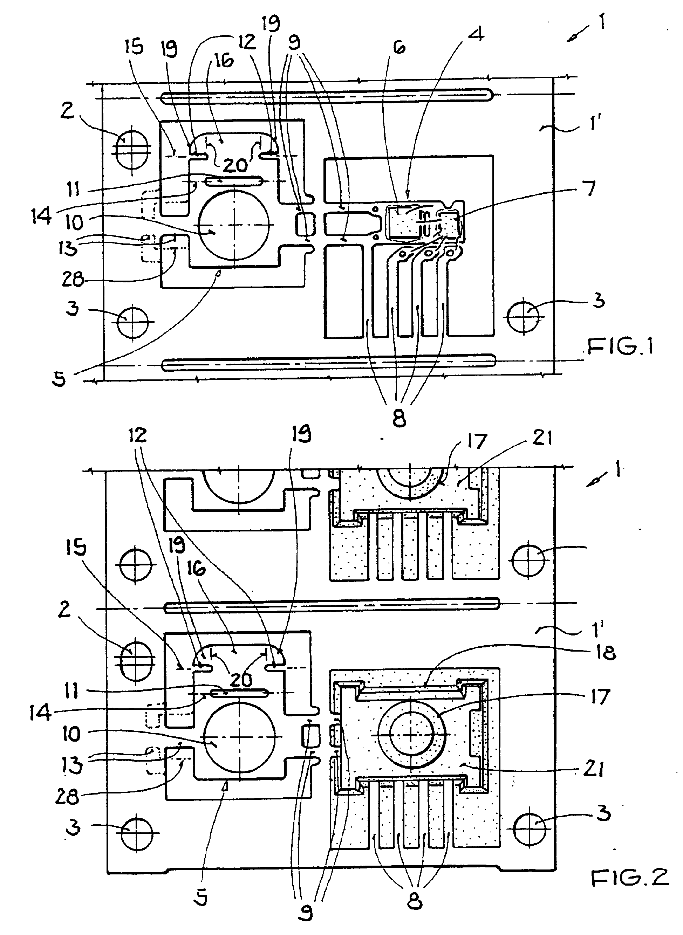

Die **Fig. 1** zeigt einen Teil eines Leiterstreifens **1** mit einem Rahmen **1',** wobei der Leiterstreifen **1** auf bekannte Art und Weise durch Stanzen oder Ätzen aus einem dünnen, länglichen Blech hergestellt ist und längliche Positionieröffnungen **2,** runde Transportöffnungen **3** und Anschlussbeinchen **8** aufweist. Weiterhin besteht der Leiterstreifen **1** aus einem ersten Leiterstreifenbereich **4** und einem zweiten Leiterstreifenbereich **5,** wobei der erste Leiterstreifenbereich **4** mit einem optoelektronischen Halbleiterbauelement **6,** beispielsweise einem Empfänger für infrarote Strahlung, und mit einem elektronischen Halbleiterbauelement **7,** beispielsweise einem Integrierten Schaltkreis, bestückt ist. Der erste Leiterstreifenbereich **4** kann mit weiteren optoelektronischen und elektronischen Halbleiterbauelementen bestückt sein.

Die Anschlussbeinchen **8** werden zu einem späteren Zeitpunkt zweifach umgebogen und in eine bestimmte Form gebogen und dienen vorläufig dazu, den ersten Leiterstreifenbereich **4** mit dem Rahmen **1'** zu verbinden. Eines der Anschlussbeinchen **8,** das später mit Masse verbunden wird, ist Teil des Leiterstreifens **1,** so dass beide Leiterstreifenbereiche **4** und **5** auf Masse liegen. Die Halbleiterbauelemente **6, 7** sind auf bekannte Weise miteinander oder mit dem Leiterstreifen **1** kontaktiert.

Der zweite Leiterstreifenbereich **5** ist durch einen oder mehrere Stege **9** mit dem ersten Leiterstreifenbereich **4** verbunden und weist eine erste Öffnung **10,** eine zweite Öffnung **11,** zwei Einkerbungen oder Einschnitte **12** und einen weiteren, mit dem Rahmen des Leiterstreifens **1** verbundenen Steg **13** auf. Der Steg **13** dient zwar lediglich zur Verbindung des zweiten Leiterstreifenbereichs **5** mit dem Rahmen **1'** und wird zu einem späteren Zeitpunkt vom Leiterstreifenbereich **5** abgetrennt; er kann aber auch als Teil der Abschirmung mit dem Leiterstreifenbereich **5** verbunden bleiben (und wird dann vom Rahmen **1'** abgetrennt). Statt der zwei Stege **9** zum Verbinden der beiden Leiterstreifenbereiche **4** und **5** kann auch ein einziger, breiterer Steg **9** verwendet werden. Zwei Flügel **19** schließen sich an die beiden Einkerbungen oder Einschnitte **12** an und werden beim Herstellen des Leiterstreifens **1** entlang einer jeweiligen Biegelinie **20** um einen kleinen Winkel abgewinkelt (der Zweck wird weiter unten erläutert).

Die erste Öffnung **10** weist vorteilhaft eine kreisrunde Form mit einem bestimmten Durchmesser auf und befindet sich ungefähr in der Mitte des Leiterstreifenbereichs **5;** die zweite Öffnung **11** weist vorzugsweise eine längliche Form mit einer Längsachse **14** auf. Die Längsachse **14** stellt auch eine Biegelinie dar, entlang der zu einem späteren Zeitpunkt ein Teilstück **16** des zweiten Leiterstreifenbereichs **5** ungefähr rechtwinklig abgebogen wird. Die beiden Einkerbungen oder Einschnitte **12** verlaufen entlang einer Linie **15,** die wiederum parallel zur Biegelinie bzw. Längsachse. **14** der Öffnung **11** verläuft.

Die **Fig. 2** zeigt den Leiterstreifen **1** mit dem unveränderten Leiterstreifenbereich **5.** Der erste Leiterstreifenbereich **4** wird mit den darauf montierten Halbleiterbauelementen **6, 7** (Fig. 1) zur Herstellung eines Gehäuses **21** mit einem thermo- oder duroplastischen und für die infrarote Strahlung transparenten Kunststoff umhüllt, beispielsweise mit einem spritzgussfähigen Kunstharz mittels eines Mouldprozesses.

In das Gehäuse **21** ist eine runde, abgeflachte Linse **17** zum Bündeln der infraroten Strahlung integriert. Form und Durchmesser der Linse **17** und Form und Durchmesser der Öffnung **10** des zweiten Leiterstreifenbereichs **5** sind dabei auf einander abgestimmt, so dass die Linse **17** durch die Öffnung **10** hindurch passt. Weiterhin weist das Gehäuse **21** eine Aussparung **18** auf, die so bemaßt ist, dass das abzubiegende Teilstück **16** des zweiten Leiterstreifenbereichs **5** in diese Aussparung **18** passt.

Falls der Steg **13** zur Abschirmung mit dem zweiten Leiterstreifenbereich **5** verbunden bleibt, kann das Gehäuse **21** vorteilhaft eine weitere Aussparung aufweisen, die so bemessen ist, dass sie den Steg **13** aufnehmen kann. Die Linse **17** ist abgeflacht und erhält dadurch eine Greiffläche **27**, damit an dieser Greiffläche **27** die Saugnadel eines Bestückungsautomaten andocken kann.

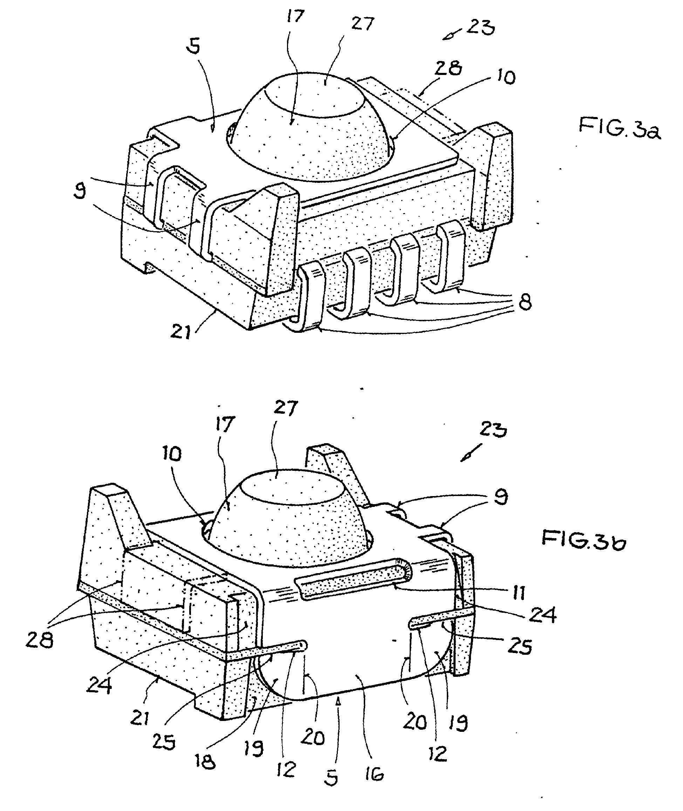

Die **Fig. 3a** und **3b** zeigen jeweils eine perspektivische Ansicht eines fertig montierten optoelektronischen Bauelements **23**, bei dem es sich beispielsweise um ein Photomodul handelt, das in Audio- oder Videoanlagen eingebaut ist und mittels Infrarotstrahlung Steuerbefehle einer Fernbedienung empfängt und als elektrische Signale weitergibt.

Die Anschlussbeinchen **8** sind zweifach umgebogen, so dass das Bauelement **23** in Top-View-Position oder in Side-View-Position auf einer Leiterplatte montiert werden kann. Die Stege **9** sind ebenfalls zweifach umgebogen und der zweite Leiterstreifenbereich **5** somit als Abschirmung gegen elektromagnetische Störstrahlung derart über das Gehäuse **21** gefaltet, dass die Linse **17** durch die Öffnung **10** ragt. Falls der Steg **13** nicht entfernt ist, kann er als (strichpunktiert gezeichnetes) seitliches Abschirmschild **28** einfach abgewinkelt sein. Das seitliche Abschirmschild **28** kann auch länger gestaltet, zweifach abgewinkelt und innerhalb einer gegebenenfalls vorhandenen Aussparung um das Gehäuse **21** gebogen sein, so dass der abschirmende zweite Leiterstreifenbereich **5** nicht zurück federt. Diese Ausfüuhrungsform, die das Zurückfedern des Leiterstreitenbereischs 5 verhindert, fäallt jedoch nicht unter die Ansprüche.

Eine andere, erfindungsgemäße, Möglichkeit, das Zurückfedern des Leiterstreifenbereichs **5** zu verhindern, besteht darin, in das Gehäuse **21** innerhalb der Ausnehmung **18** eine Schräge **24** anzubringen, die als scharfkantige Stufe **25** endet. Nachdem das Teil **16** des Leiterstreifenbereichs **5** entlang der Linie **14** ungefähr rechtwinklig abgebogen sind, gleiten die um einen kleinen Winkel entlang der jeweiligen Biegelinie **20** abgewinkelten Flügel **19** beim Umfalten des zweiten Leiterstreifenbereichs **5** entlang der Schräge **24** und rasten an der Stufe **25** ein, wodurch der gesamte Leiterstreifenbereich **5** in dieser Position gehalten und am Zurückfedern gehindert wird.

Die Erfindung zeigt eine einfache Möglichkeit, elektronische oder optoelektronische Bauelemente wie beispielsweise Photomodule vor elektromagnetischer Störstrahlung zu schützen.

## Patentansprüche

1. Optoelektronisches Bauelement (23) mit Leiterstreifenaufbau, wobei auf einem ersten mit Masse verbundenen Leiterstreifenbereich (4) elektronische und optoelektronische Halbleiterbauelemente (6, 7) angeordnet und von einem Gehäuses (21) aus einem thermo- oder duroplastischen Kunststoff umgeben sind, wobei ein zweiter, ebenfalls mit Masse verbundener Leiterstreifenbereich (5) so um das Gehäuse (21) gefaltet ist, dass er die Halbleiterbauelemente (6, 7) vor elektromagnetischer Störstrahlung abschirmt, wobei der zweite Leiterstreifenbereich (5) mit dem ersten Leiterstreifenbereich (4) verbunden ist, und wobei der zweite Leiterstreifenbereich (5) aus dem Gehäuse (21) heraus ragt,
**dadurch gekennzeichnet,**
**dass** der zweite Leiterstreifenbereich (5) ein abgebogenes Teilstück (16) mit zwei Einkerbungen oder Einschnitten (12) aufweist, wobei sich an jede Einkerbung oder Einschnitt (12) ein abgewinkelter Flügel (19) anschließt, wobei das Gehäuse (21) eine Schräge (24) mit einer abschließenden Stufe (25) aufweist, und wobei die abgewinkelten Flügel (19) bei umgefaltetem zweiten Leiterstreifenbereich (5) in der Stufe (25) eingerastet sind.

2. Optoelektronisches Bauelement (23) nach Anspruch 1, **dadurch gekennzeichnet, dass** die beiden Leiterstreifenbereiche (4, 5) durch einen oder mehrere Stege (9) miteinander verbunden sind.

3. Optoelektronisches Bauelement (23) nach Anspruch 1 oder 2, **dadurch gekennzeichnet, dass** in das Gehäuse (21) eine Linse (17) integriert ist.

4. Optoelektronisches Bauelement (23) nach einem der Ansprüche 1 bis 3, **dadurch gekennzeichnet, dass** der zweite Leiterstreifenbereich (5) eine Öffnung (10) aufweist.

5. Optoelektronisches Bauelement (23) nach den Ansprüchen 3 und 4, **dadurch gekennzeichnet, dass** Form und Durchmesser der Linse (17) und Form und Durchmesser der Öffnung (10) auf einander abgestimmt sind, wobei die Linse (17) durch die Öffnung (10) des zweiten Leiterstreifenbereichs (5) ragt.

6. Optoelektronisches Bauelement (23) nach einem der Ansprüche 1 bis 5, **dadurch gekennzeichnet, dass** der zweite Leiterstreifenbereich (5) einen weiteren Steg (13) aufweist.

7. Optoelektronisches Bauelement (23) nach Anspruch 6, **dadurch gekennzeichnet, dass** der Steg (13) bei umgefaltetem Leiterstreifenbereich (5) um das Gehäuse (21) gebogen ist.

8. Optoelektronisches Bauelement (23) nach Anspruch 6 oder 7, **dadurch gekennzeichnet, dass** das Gehäuse (21) für den Steg (13) eine Ausnehmung aufweist.

9. Optoelektronisches Bauelement (23) nach einem der Ansprüche 1 bis 8, **dadurch gekennzeichnet, dass** das Gehäuse (21) eine Aussparung (18) aufweist, die so bemaßt ist, dass das abgebogene Teilstück (16) des zweiten Leiterstreifenbereichs (5) in die Aussparung (18) passt.

10. Verfahren zum Herstellen eines optoelektronischen Bauelements (23), mit folgenden Verfahrensschritten:
a) Bereitstellen eines mit Masse verbundenen Leiterstreifens (1) mit einem ersten Leiterstreifenbereich (4),
b) Montieren und Kontaktieren von elektronischen und optoelektronischen Halbleiterbauelementen (6, 7) auf dem ersten Leiterstreifenbereich (4),
c) Herstellen eines Gehäuses (21) um den ersten Leiterstreifenbereich (4) und die Halbleiterbauelementen (6, 7) durch Moulden mit einem thermo- oder duroplastischen Kunststoff,
d) wobei ein zweiter Leiterstreifenbereich (5), der mit dem ersten Leiterstreifenbereich (4) verbunden ist, als elektromagnetische Abschirmung um das Gehäuse (21) gefaltet wird **dadurch gekennzeichnet,**
**dass** der zweite Leiterstreifenbereich (5) ein abgebogenes Teilstück (16) mit zwei Einkerbungen oder Einschnitten (12) aufweist, wobei sich an jede Einkerbung oder Einschnitt (12) ein abgewinkelter Flügel (19) anschließt, wobei das Gehäuse (21) eine Schräge (24) mit einer abschließenden Stufe (25) aufweist, und wobei die abgewinkelten Flügel (19) beim Umfalten des zweiten Leiterstreifenbereichs(5) in der Stufe (25) eingerastet werden.

## Claims

1. An optoelectronic component (23) having a leadframe structure,
wherein electronic and optoelectronic semiconductor components (6, 7) are arranged on a first leadframe region (4) connected to ground and are surrounded by a housing (21) of a thermoplastic or thermosetting plastic, wherein a second leadframe region (5), likewise connected to ground, is folded around the housing (21) such that it screens the semiconductor components (6, 7) from electromagnetic interference radiation, with the second leadframe region (5) being connected to the first leadframe region (4) and with the second leadframe region (5) projecting out of the housing (21), **characterised in that**
the second leadframe region (5) has a bent over portion (16) with two notches or incisions (12), with an angled wing (19) adjoining each notch or incision (12), with the housing (21) having a ramp (24) with a terminal step (25) and with the angled wings (19) being latched in the step (25) when the second leadframe region (5) is folded over.

2. An optoelectronic component (23) in accordance with claim 1, **characterised in that** the two leadframe regions (4, 5) are connected to one another by one or more webs (9).

3. An optoelectronic component (23), in accordance with claim 1 or claim 2, **characterised in that** a lens (17) is integrated into the housing (21).

4. An optoelectronic component (23) in accordance with any one of the claims 1 to 3, **characterised in that** the second leadframe region (5) has an opening (10).

5. An optoelectronic component (23) in accordance with claims 3 and 4, **characterised in that** the shape and diameter of the lens (17) are matched to the shape and diameter of the opening (10), with the lens (17) projecting through the opening (10) of the second leadframe region (5).

6. An optoelectronic component (23) in accordance with any one of the claims 1 to 5, **characterised in that** the second leadframe region (5) has a further web (13).

7. An optoelectronic component (23) in accordance with claim 6, **characterised in that** the web (13) is bent around the housing (21) when the leadframe region (5) is folded over.

8. An optoelectronic component (23) in accordance with claim 6 or claim 7, **characterised in that** the housing (21) has a cut-out for the web (13).

9. An optoelectronic component (23) in accordance with any one of the claims 1 to 8, **characterised in that** the housing (21) has a recess (18) which is dimensioned such that the bent over portion (16) of the second leadframe region (5) fits into the recess (18).

10. A method of manufacturing an optoelectronic component (23) comprising the following method steps:
a) providing a leadframe (1) connected to ground with a first leadframe region (4);
b) assembling and contacting electronic and optoelectronic semiconductor components (6, 7) on the first leadframe region (4);
c) manufacturing a housing (21) around the first leadframe region (4) and the semiconductor components (6, 7) by moulding with a thermoplastic or thermosetting plastic;
d) with a second leadframe region (5) which is connected to the first leadframe region (4) being folded around the housing (21) as an electromagnetic screen,
**characterised in that**
the second leadframe region (5) has a bent over portion (16) with two notches or incisions (12), with an angled wing (19) adjoining each notch or incision (12), with the housing (21) having a ramp (24) with a terminal step (25) and with the angled wings (19) being latched in the step (25) on the folding over of the second leadframe region (5).

## Revendications

1. Composant optoélectronique (23) avec une structure de bandes conductrices, dans lequel des composants semi-conducteurs électroniques et optoélectroniques (6, 7) sont agencés sur une première région (4) à bandes conductrices connectée à la masse et sont entourés par un boîtier (21) en une matière thermoplastique ou thermodurcissable, dans lequel une seconde région (5) à bandes conductrices, également connectée à la masse, est repliée autour du boîtier (21) de telle manière qu'elle fait écran pour les composants semi-conducteurs (6, 7) vis-à-vis des rayonnements parasites électromagnétiques, dans lequel la seconde région (5) à bandes conductrices est connectée à la première région (4) à bandes conductrices, et la seconde région (5) à bandes conductrices fait saillie hors du boîtier (21),
**caractérisé en ce que**
la seconde région (5) à bandes conductrices comprend une pièce partielle recourbée (16) avec deux encoches ou entailles (12), avec une ailette coudée (19) qui se raccorde à chaque encoche ou entaille (12), le boîtier (21) comportant une pente (24) avec un gradin (25) terminal, et dans lequel les ailettes coudées (19) sont enclenchées dans le gradin (25) lorsque la seconde région (5) à bandes conductrices est repliée.

2. Composant optoélectronique (23) selon la revendication 1, **caractérisé en ce que** les deux régions (4, 5) à bandes conductrices sont reliées l'une à l'autre par une ou plusieurs barrettes (9).

3. Composant optoélectronique (23) selon la revendication 1 ou 2, **caractérisé en ce qu'**une lentille (17) est intégré dans le boîtier (21).

4. Composant optoélectronique (23) selon l'une des revendications 1 à 3, **caractérisé en ce que** la seconde région (5) à bandes conductrices comporte une ouverture (10).

5. Composant optoélectronique (23) selon les revendications 3 et 4, **caractérisé en ce que** la forme et le diamètre de la lentille (17) et la forme et le diamètre de l'ouverture (10) sont accordés les uns aux autres, et la lentille (17) passe à travers l'ouverture (10) de la seconde région (5) à bandes conductrices.

6. Composant optoélectronique (23) selon l'une des revendications 1 à 5, **caractérisé en ce que** la seconde région (5) à bandes conductrices comprend une autre barrette (13).

7. Composant optoélectronique (23) selon la revendication 6, **caractérisé en ce que** la barrette (13) est recourbée autour du boîtier (21) lorsque la région (5) à bandes conductrices est repliée.

8. Composant optoélectronique (23) selon la revendication 6 ou 7, **caractérisé en ce que** le boîtier (21) comporte un évidement pour la barrette (13).

9. Composant optoélectronique (23) selon l'une des revendications 1 à 8, **caractérisé en ce que** le boîtier (21) comporte une échancrure (18) qui a une dimension telle que la pièce partielle recourbée (16) de la seconde région (5) à bandes conductrices s'ajuste dans l'échancrure (18).

10. Procédé pour réaliser un composant électronique (23), comportant les étapes de procédé suivantes :
a) préparation d'une première bande conductrice (1) connectée à la masse avec une première région (4) à bandes conductrices,
b) montage et mise en contact de composants semi-conducteurs électroniques et optoélectroniques (6, 7) sur la première région (4) à bandes conductrices,
c) réalisation d'un boîtier (21) autour de la première région (4) à bandes conductrices et des composants semi-conducteurs (6, 7) par moulage avec une matière thermoplastique ou thermodurcissable,
d) dans lequel une seconde région (5) à bandes conductrices, qui est reliée à la première région (4) à bandes conductrices, est pliée autour du boîtier (21) à titre d'écran électromagnétique,
**caractérisé en ce que**
la seconde région (5) à bandes conductrices comprend une pièce partielle recourbée (16) avec deux encoches ou entailles (12), avec une ailette coudée (19) qui se raccorde à chaque encoche ou entaille (12), le boîtier (21) comportant une pente (24) avec un gradin terminal (25), et dans lequel les ailettes coudées (19) sont enclenchées dans le gradin lorsqu'on replie la seconde région (5) à bandes conductrices.
